# EUROPEAN PATENT APPLICATION

(11) **EP 4 757 534 A1**
(43) Date of publication of application: **10.06.2026**
(21) Application number: 24218172.5
(22) Date of filing: 06.12.2024
(51) Int. Cl.: H10D 89/10, H10D 62/10, H01L 23/528, H10D 84/85, H10D 30/67, H10D 84/03, H10D 88/00, H10D 84/90

(54) **A SEMICONDUCTOR DEVICE**

(71) Applicant: IMEC vzw, 3001 Heverlee (BE)
(72) Inventor: MIRABELLI, Gioele, 3000 Leuven (BE); HELLINGS, Geert, 1500 Halle (BE); ZOGRAFOS, Odysseas, 3010 Kessel-Lo (BE); KÜKNER, Selahaddin Halil, 3053 Haasrode (BE); LIN, Ji-Yung, 3001 Heverlee (BE)
(74) Representative: Lind Edlund Kenamets Intellectual Property AB

(57) **Abstract**

In an aspect there is provided a semiconductor device comprising:
a first and second power rail structure extending in parallel, each comprising a bottom power rail and a top power rail arranged above the bottom power rail;
a row of local interconnects arranged between and extending in parallel to the first and second rows of CFET devices;
a first and second row of complementary field-effect transistor, CFET, devices extending in parallel to the first and second power rail structures, wherein the first row of CFET devices is arranged between the first power rail structure and the row of local interconnects, and the second row of CFET devices is arranged between the second power rail structure and the row of local interconnects;
a logic cell comprising
at least one CFET device of the first row of CFET devices configured to implement a first logic gate, and a first local interconnect of the row of local interconnects configured to interconnect a top and bottom source/drain, S/D, of a first CFET device of the at least one CFET device of the first row of CFET devices; and
at least one CFET device of the second row of CFET devices configured to implement a second logic gate, and a second local interconnect of the row of local interconnects configured to interconnect a top and bottom S/D of a second CFET device of the at least one CFET device of the second row of CFET devices,
wherein the first logic gate is connected to first input and output pins of the logic cell and the second logic gate is connected to second input and output pins of the logic cell, and
wherein the first power rail structure is configured to power the first logic gate and the second power rail structure is configured to power the second logic gate.

## Description

### TECHNICAL FIELD

The present invention generally relates to a semiconductor device, and more specifically to a semiconductor device comprising rows of Complementary Field-Effect Transistor devices.

### BACKGROUND

The Complementary Field-Effect Transistor (CFET) is a stacked transistor structure comprising a bottom transistor and a top transistor stacked over the bottom transistor. The bottom and top transistors (or bottom and top devices) are of complementary conductivity types (e.g., an NMOS device stacked on top of a PMOS device, or vice versa). The CFET thus allows a reduced footprint compared to a traditional side-by-side arrangement of a complementary transistor pair. The CFET is hence an enabling technology for denser and more area-efficient circuits.

Standard cell methodology enables a circuit designer to efficiently design an integrated circuit (IC) by combining circuit cells, such as standard cells (SDCs) from a standard cell library. Each standard cell of a standard cell library may comprise a set of active devices (e.g., transistors such as CFETs), and associated metal interconnects and be configured to provide a certain circuit function. A significant portion of the functionality of an IC is provided by logic cells, e.g., implementing various logic gates such as NOT, AND, OR, NOR, etc.

To increase the device density and performance of ICs, considerable effort has been put into advancing design and process technology to reduce the cell height and cell area of standard logic cells, and to optimize usage of routing resources in the interconnect layers above the cell area (e.g., in the "M0" interconnect layer) to mitigate routing congestion and enable standard cell track height reduction.

### SUMMARY

However, as realized by the inventors, a challenge with further scaling cell height and cell area of CFET-based logic cells, is that conventional CFET-based logic cell designs typically comprise a pair of power rails on either side of each row of CFETs for supplying power (VSS and VDD) to the bottom and top transistor tiers. The space between neighboring rows of CFETs hence needs to accommodate interconnects (e.g., vertical connects such as tall vias) both for connecting the bottom and top transistors along the pair of rows of CFETs to the associated power rail, as well as for routing signals to and/or between the bottom and top transistor tiers. This may contribute to routing congestion between the rows and limit the possibility to scale the height of the circuit cells (as measured across the row direction).

In view of the above, it is an object of the present invention to provide a semiconductor device and logic cell having a design utilizing CFETs but avoiding or mitigating the above-mentioned issues. Further and alternative objectives may be understood from the following.

According to a first aspect of the present invention, there is provided a semiconductor device comprising:
a first and second power rail structure extending in parallel, each comprising a bottom power rail and a top power rail arranged above the bottom power rail;
a row of local interconnects arranged between and extending in parallel to the first and second rows of CFET devices;
a first and second row of complementary field-effect transistor, CFET, devices extending in parallel to the first and second power rail structures, wherein the first row of CFET devices is arranged between the first power rail structure and the row of local interconnects, and the second row of CFET devices is arranged between the second power rail structure and the row of local interconnects;
a logic cell comprising
at least one CFET device of the first row of CFET devices configured to implement a first logic gate, and a first local interconnect of the row of local interconnects configured to interconnect a top and bottom source/drain, S/D, of a first CFET device of the at least one CFET device of the first row of CFET devices; and
at least one CFET device of the second row of CFET devices configured to implement a second logic gate, and a second local interconnect of the row of local interconnects configured to interconnect a top and bottom S/D of a second CFET device of the at least one CFET device of the second row of CFET devices,
wherein the first logic gate is connected to first input and output pins of the logic cell and the second logic gate is connected to second input and output pins of the logic cell, and
wherein the first power rail structure is configured to power the first logic gate and the second power rail structure is configured to power the second logic gate.

Contrary to conventional CFET-based circuit implementations, the present semiconductor device comprises a "stacked" pair of power rail structures on either side of a pair of rows of CFET devices. Since each power rail structure comprises a bottom power rail and a top power rail stacked over the bottom power rail, the bottom and top transistors of the CFET devices of the first and second rows (hereinafter interchangeably "first and second CFET rows") may thus be supplied with power from a single side, as opposed to two sides as in conventional implementations. Accordingly, the space or "track" between the two CFET rows which in conventional implementations would be used both for supplying power and signals between bottom and top transistors of the first and second CFET rows, may hence here be used to accommodate a row of local interconnects for interconnecting bottom and top S/Ds of bottom and top transistor of the respective CFET rows. A competition between power routing and signal routing within a given logic cell disposed along the rows of CFET devices may thus be avoided.

This configuration of a pair of consecutive stacked power rail structures surrounding a pair of first and second rows of CFET devices may in the following be referred to as a "double-row configuration" or a "double-row CFET" and hence enables routing congestion between the first and second CFET rows to be reduced, which in turn may facilitate scaled cell height and low track height implementations of logic cells, such as standard logic cells.

The semiconductor device of the first aspect further takes advantage of the double-row configuration in that the logic cell uses one or more CFET devices of the first CFET row to implement a first logic gate and one or more CFET devices of the second CFET row to implement a second logic gate. Hence, two functionally independent logic gates may be realized within a same logic cell with a cell height spanning across the width of the double-row configuration (i.e., corresponding to the pitch of the first and second power rail structures).

In some embodiments, the bottom power rails are arranged in a bottom transistor tier comprising the bottom transistors of the first and second rows of CFET devices, or in a backside interconnect layer, and/or wherein the top power rails are arranged in a top transistor tier comprising the top transistors of the first and second rows of CFET devices.

The bottom and top power rails need hence not contribute appreciably to routing congestion in interconnect layers of a frontside interconnect structure over the top transistor tier. Rather, the bottom and top transistors of the CFET devices along any given CFET row may be simply coupled with a neighboring bottom or top power rail by a lateral extension (i.e., transverse to the row directions) of its S/D contact portion, to intercept the respective power rail structures. The first and second power rail structures may advantageously be aligned with first and second cell boundaries of the logic cell. Thus, the S/D contact portions may extend to overlap the first or second cell boundary.

In some embodiments, the logic cell further comprises:
a first S/D contact structure comprising a bottom S/D contact portion contacting the bottom S/D of the first CFET device, a top S/D contact portion contacting the top S/D of the first CFET device, and the first local interconnect interconnecting the bottom and top S/D contact portions; and
a second S/D contact structure comprising a bottom S/D contact portion contacting the bottom S/D of the second CFET device, a top S/D contact portion contacting the top S/D of the second CFET device, and the second local interconnect interconnecting the bottom and top S/D contact portions.

The bottom-top S/D interconnection may hence be realized by interconnecting respective bottom and top S/D contact portions with the respective local interconnect of the row of local interconnects arranged between the first and second CFET rows.

A benefit with realizing the bottom-to-top S/D interconnection using the row of local interconnects is that it obviates the need for providing a "S/D contact merge layer" vertically between the bottom and top S/D contact portions, which may introduce additional complexities during fabrication, in particular at aggressively scaled cell heights. Thus, the bottom and top S/D contact portions may be vertically spaced apart from each other, wherein the interconnect segment may be arranged laterally adjacent to and in abutment with the bottom and top S/D contact portions to interconnect the same

In some embodiments, the first S/D contact structure is connected to the first output pin of the logic cell and the second S/D contact is connected to the second output pin of the logic cell. Hence, the respective interconnected S/D features of the first and second CFET devices may be configured as respective output nodes of the first and second logic gates.

In some embodiments, each of the CFET devices comprises a gate shared by a bottom and top transistor of the respective CFET device and connected to a respective input pin of the logic cell. Hence, the respective gate of the first and second CFET devices may be configured as respective input nodes of the first and second logic gates.

In some embodiments, the first logic gate is implemented by N ≥ 1 CFET devices of the first row of CFET devices and second logic gate is implemented by N CFET devices of the second row of CFET devices. The first and second logic gates may thus be implemented by a same number of CFET devices of the respective rows. For example, the first logic gate may be implemented by one CFET device of the first CFET row and the second logic gate may be implemented by one CFET device of the second CFET row. As another example, the first logic gate may be implemented by two CFET devices of the first CFET row and the second logic gate may be implemented by two CFET devices of the second CFET row. It is to be noted that the at least one CFET device of the respective rows / logic gates of the logic cell are arranged directly opposite each other.

In some embodiments, the at least one CFET device of first logic gate and the at least one CFET device of the second logic gate are arranged in respective half-cells of the logic cell, and wherein each half-cell has a cell width corresponding to (N+1) times a contacted poly pitch, CPP, of the CFET devices. The first and second logic cells may thus be realized in respective half-cells of equal cell widths. In the present disclosure, that the CFET devices are arranged in respective "half-cells" of the logic cell here means that the at least one CFET device of the first logic gate and the at least one CFET device of the second logic gate are arranged in respective (non-overlapping) sub-cells of equal footprints corresponding to half the footprint of the logic cell.

In some embodiments, each half-cell comprises a respective pair of dummy gates, wherein the N CFET devices of each logic gate is arranged between the respective pair of dummy gates. The first and second output pins of the logic cell (and thus the respective output nodes of the first and second logic gates) need hence not be shared with a neighboring logic cell disposed next to the logic cell along the row of CFETs.

In some embodiments, the number of CFETs of each logic gate is N ≥ 2, wherein the logic cell comprises a respective backside signal track aligned with each of the first and second rows of CFET devices and each comprising a metal line interconnecting a pair of non-neighboring S/Ds of a pair of CFET devices of the respective row of CFET devices. Hence, intra-cell signaling between S/Ds spaced apart by gates of one or more CFET devices may be provided by backside signal tracks. Intra-cell S/D connections may thus be provided without increased routing congestion in the frontside interconnect structure.

In some embodiments, the first and second logic gates are identical logic gates. That the first and second logic gates are identical logic gates here means that they perform a same logic / Boolean function.

In some embodiments, a circuit layout of the logic cell is point symmetric. That is, the circuit layout (i.e., the layout of CFET devices, gates of the CFET devices, local interconnects, S/D contacts, etc.) is symmetric about a center point of the logic cell (i.e., rotationally symmetric about the center of the logic cell). This means that the logic cell may implement first and second identical logic gates in respective half-cells with identical but rotated layouts (e.g., rotated by 180 degrees with respect to each other).

In some embodiments, the first and second logic gates are inverter (NOT) gates, NAND gates, NOR gates, AND gates or OR gates. Hence, the logic cell may implement multi-bit NOT, NAND, NOR, AND or OR gates, by comprising two such gates within the footprint of the logic cell, each logic gate being connected to respective input and output pins of the logic cell.

In some embodiments, the first logic gate is implemented by N = 1 CFET devices of the first row of CFET devices and second logic gate is implemented by N = 1 CFET devices of the second row of CFET devices, and the first and second logic gates are inverter gates. Hence, the logic cell may implement two NOT gates by means of a single CFET device of each CFET row.

In some embodiments, the first logic gate is implemented by N = 2 CFET devices of the first row of CFET devices and second logic gate is implemented by N =2 CFET devices of the second row of CFET devices, and the first and second logic gates are AND, OR, NOR or NAND gates and N=2. Hence, the logic cell may implement two AND, OR, NOR or NAND gates by means of two CFET devices of each CFET row.

### BRIEF DESCRIPTION OF THE DRAWINGS

The above, as well as additional objects, embodiments, features and effects of the present disclosure, may be better understood through the following illustrative and non-limiting detailed description, with reference to the appended drawings. In the drawings like reference numerals will be used for like elements unless stated otherwise.
Fig. 1 schematically shows an example of two CFET rows in a double-row configuration.
Fig. 2 schematically shows a further example of two CFET rows in a double-row configuration.
Fig. 3 schematically shows a top-down view of a semiconductor device comprising double-row CFETs according to an example.
Fig. 4 schematically shows, as a comparative example, a logic cell comprising a double-row CFET implementing a single inverter gate.
Fig. 5 schematically shows a logic cell comprising a double-row CFET implementing two inverter gates.
Fig. 6a-b shows example circuit layouts of top and bottom transistor tiers, respectively, of the logic cell of Fig. 5.
Fig. 7 schematically shows a logic cell comprising a double-row CFET implementing two NAND gates.
Fig. 8a-c show example circuit layouts of top and bottom transistor tiers of the logic cell of Fig. 7.
Fig. 9a-c schematically show further examples of logic cells comprising a double-row CFET and implementing two identical logic gates.

### DETAILED DESCRIPTION

In the following, a detailed description of example implementations of logic cells, such as logic standard cells, based on the so-called double-row configuration / double-row CFET will be provided with reference to the drawings. The drawings are only schematic and the relative dimensions of illustrated elements, such as layers or other structures, may be exaggerated and not drawn to scale. Rather the dimensions may be adapted for illustrational clarity and to facilitate understanding. When present in the figures, the indicated axes X, Y and Z point in a first horizontal direction, a second horizontal direction, and a vertical direction, respectively. As is apparent from the figures, the X direction corresponds to a width dimension (cell width) of the logic cells and a direction of extension of the CFET rows and local interconnect rows (i.e., the "row direction"). The X direction is also the direction of extension of the power rail structures and depicted routing tracks. The Y direction corresponds to a height dimension (cell height) of the logic cells, transverse to the first / row direction X. By the term "horizontal" is herein meant a direction parallel to main plane of extension of an active device tier or active device layer comprising the active devices (e.g., CFET devices) of the semiconductor device. Where the semiconductor device comprises a substrate, the term horizontal may equivalently be understood as a direction parallel to the substrate, i.e. parallel to a main surface (e.g., a frontside) of the substrate. The term "lateral" refers to a horizontal direction, typically transverse to the X direction. The term "horizontal" is equivalently to be understood as a direction parallel to the footprint / area of the logic cells. By the term "vertical" is herein meant a direction normal or transverse to the horizontal XY-plane, or equivalently, a direction normal or transverse to the active device tier or substrate. Accordingly, terms indicating relative vertical arrangement of elements, such as "top", "upper", "bottom", "lower" and the like, are to be understood in relation to the vertical direction. It is to be noted that when an element (e.g. an interconnect, a contact, a layer or other structure) is referred to as being "on" another element, it can be directly on the other element or on one or more intermediate elements on the other element. Conversely, when an element is referred to as being "directly on" another element, there is no intermediate element and the element is thus abutting (i.e., physically contacting) the other element. It is further to be noted that terms such as "first" and "second" etc. with reference to elements (e.g. layers or other structures) may be used herein as labels to facilitate distinguishing between different elements, and need not necessarily imply that such elements are arranged or performed in that particular order, unless stated otherwise. Furthermore, by the term "CFET" or "CFET device" is herein meant a device, more specifically a stacked transistor device, comprising a bottom transistor of a first conductivity type and a top transistor of a second conductive type opposite the first conductivity type stacked on top of / over the bottom transistor, e.g. an NMOS top device stacked on top of a PMOS bottom device, or vice versa. More specifically, the top device is arranged within the footprint of the bottom device, at least substantially. The bottom transistor is comprised in a bottom transistor tier of the semiconductor device / logic cell and the top device is comprised in a top transistor tier of the semiconductor device / logic cell. The bottom and top transistor tiers are each comprised in an active device layer.

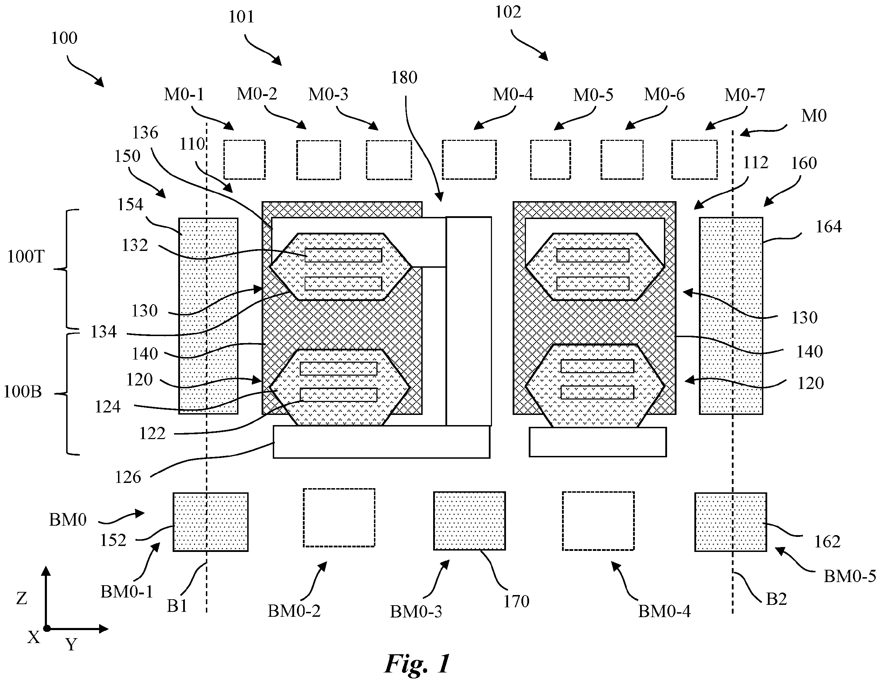

As mentioned above, the logic cells to be disclosed in the following are based on the double-row CFET. Examples of double-row CFETs will now be discussed with reference to Fig. 1-2.

Fig. 1 schematically shows an example of two corresponding first and second CFET devices 110, 112 of a semiconductor device 100. The CFET devices 110, 112 are double-row CFETs and thus comprised in respective CFET rows 101, 102 extending in parallel in the X direction along a substrate of the semiconductor device 100 (not individually shown). Each CFET device 110, 112 comprises a bottom transistor 120 and a top transistor 130 stacked on top of the bottom transistor 120. The bottom transistor 120 is comprised in a bottom transistor tier 100B and the top transistor 130 is comprised in a top transistor tier 100T.

The view of Fig. 1 is a partial cross section-partial projection, to allow a simultaneous view of respective S/Ds (i.e., S/D regions or features) and channel regions of the CFET devices 110, 112. Reference will in the following mainly be made to the CFET device 110, however the discussion applies as shown in Fig. 1 correspondingly to the other CFET device 120.

The bottom transistor 120 comprises, as shown, a bottom S/D 124 (e.g., an epitaxial S/D body) and a bottom channel structure 122 (e.g., one or more stacked nanosheets, typically Si or SiGe-based) extending in the X direction between the bottom S/D 124 and a further bottom S/D region at an opposite side of the bottom channel structure 122, located behind the plane shown in Fig. 1.

The top transistor 130 comprises as shown corresponding features, a top S/D 134 and a top channel structure 132 (e.g., one or more stacked nanosheets) extending in the X direction between the top S/D region 12a and an opposite top S/D.

The CFET 110 further comprises a gate 140 shared by the bottom and top transistors 120, 130. The gate 140 is arranged to surround the bottom and top channel structures 122, 132 along a channel region, e.g., completely in a gate-all-around (GAA) fashion.

The CFET device 110 further comprises a S/D contact structure comprising a bottom S/D contact or contact portion 126 electrically connected to (by abutting) the bottom S/D 124, and a top S/D contact or contact portion 136 electrically connected to (by abutting) the top S/D 134. The top S/D contact portion 136 is vertically separated from the bottom S/D contact portion 126. The bottom and top S/D contact portions 126, 136, and the bottom and top S/Ds 124, 134 may as schematically shown be vertically separated in the Z direction, for instance by an intermediate insulating layer portion (e.g., an inter-layer dielectric such as silicon oxide). In Fig. 1, the bottom S/D contact portion 126 is shown as a layer-like feature abutting the bottom S/D 124 from below. However, this is just an example and the bottom S/D contact portion 126 may also be formed to wrap around the bottom S/D 124, fully or partly. This applies correspondingly to the top S/D contact portion 136. The bottom S/D contact portion 126 may also be referred to as bottom metal diffusion (sometimes denoted "BMD") while the top S/D contact portion 136 may be referred to as top metal diffusion (sometimes denoted "MD") The bottom S/D contact portion 126 may beneficially be formed during backside processing, subsequent to the frontside processing (e.g., comprising CFET device fabrication, forming the row of LIs 180 (discussed below), top transistor S/D contact patterning, frontside interconnect structure fabrication).

The two CFET rows 101, 102 are surrounded by a pair of first and second power rail structures 150, 160 extending along opposite sides of the CFET rows 101, 102. Thus the CFET rows 101, 102 are arranged between and extend in parallel to the first and second power rail structures 150, 160.

Each power rail structure 150, 160 comprises a bottom power rail 152, 162 and a top power rail 154, 164 stacked over the respective bottom power rail 152, 162, at a vertical level above the bottom power rails 152, 162. Each top power rail 154, 164 is thus arranged within the footprint of its associated bottom power rail 152, 162, at least substantially. The bottom power rails 152, 162 may be configured as pull-up voltage rails (VDD) and the top power rails 154, 164 may be configured as pull-down voltage rails (VSS), or vice versa (depending on the channel types of the bottom and top transistors 120, 130), such that each power rail structure 150, 160 may supply both a pull-up and pull-down voltage to the CFETs of the neighboring CFET row 101, 102. Thereby, each CFET device 110, 120 may be supplied power from a single side (i.e., a respective outside of the rows 101, 102).

In accordance with the double-row CFET design, the space between first and second CFET rows 101, 102 accommodates a row of local interconnects (LI) 180, one such LI 180 being visible in Fig. 1. The row of LIs 180 is arranged between and extends in parallel to the first and second CFET rows 101, 102. More specifically, the first CFET row 101 is arranged between the first power rail structure 150 and the row of LIs 180. The second CFET row 102 is arranged between the second power rail structure 150 and the row of LIs 180. The shown LI (and any number of further LIs of the row of LIs 180) is as shown arranged in, i.e., extends between the bottom and top transistor tiers 100B, 100T. The row of LIs 180 is substantially centered between the CFET rows 101, 102 and power rail structures 150, 160. The LIs 180 are distributed in the X direction. The LIs 180 may be substantially pillar or wall-shaped and vertically oriented metal interconnects. The LIs 180 have as shown a vertical extension (in the Z direction) matching a combined vertical extension of the bottom and top transistor tiers 100B, 100T. In other words, each LI 180 extends vertically between a bottom portion (bottom end portion) located in / vertically aligned with the bottom transistor tier 100B and a top portion (top end portion) located in / vertically aligned with the top transistor tier 100T. This stands in contrast to the conventionally used "tall vias", which are formed to extend continuously from the M0 interconnect layer to the bottom tier 100B, or continuously from the top tier 100T to the backside interconnect layer BM0. Hence, tall vias have a greater height and aspect ratio than the LIs 180, and therefore introduce additional complexity during fabrication. The row of LIs 180 may extend continuously between the CFET rows 101, 102, along the full length thereof, or along a part thereof (segments). Any LI of the row of LIs 180 may be coupled to one or more bottom and/or top transistors of the first or second row of CFETs 101, 102. In Fig. 1, this is shown by way of example for the CFET device 101, wherein the bottom S/D contact portion 126 extends laterally to electrically connect to (by abutting) the LI 180. Correspondingly, the top S/D contact portion 136 extends laterally to electrically connect to (by abutting) the LI 180. The top S/D contact portion 136 may as shown extend laterally to contact the LI 180 from the side (i.e., abut a sidewall of the LI 180). The bottom S/D contact portion 126 may as shown extend laterally into the footprint of the row of LIs 180 (i.e., undercutting the row of LIs 180), such that the LI 180 may contact or land on the bottom S/D contact portion 126 from above. The lateral extension of the bottom S/D contact portion 126 may also be related to the backside or frontside center tracks BM0-3 or M0-4 (discussed below). That is, the bottom S/D contact portion 126 may extend laterally into the backside or frontside center tracks BM0-3 or M0-4. However, the specific configuration may vary depending on the fabrication process. For instance, a connection between the LI 180 and the bottom S/D contact portion 126 may also be realized by forming the LI 180 to protrude vertically into the level of the bottom S/D contact portion 126, such that the bottom S/D contact portion 126 instead may contact the LI 180 from the side (i.e., abut a sidewall of the LI 180). Further, while in Fig. 1, the bottom S/D contact portion 126 is schematically shown as a single integrally formed contact body contacting the bottom S/D 124, the bottom S/D contact portion 126 may comprise a first sub-portion abutting the bottom S/D 124 and a second sub-portion abutting the first sub-portion from below. The lateral connection to the LI 180 may thus be realized by arranging the second sub-portion to extend between the first sub-portion and the LI 180. Where the bottom S/D contact portion 126 is formed during backside processing, the second sub-portion may typically be formed after forming the first sub-portion.

Fig. 1 further indicates with dashed outline rectangular boxes a set of M0 tracks (M0-1 to M0-7) of a bottom interconnect layer ("M0") layer of a frontside interconnect structure of the semiconductor device 100. The M0 tracks are arranged with a uniform pitch along the Y direction. The reference sign BM0 correspondingly indicates a set of BM0 tracks (BM0-1 to BM0-5) of a bottom BM0 layer of a backside interconnect structure of the semiconductor device 100. The BM0 tracks are arranged with a uniform pitch along the Y direction. The designation "bottom" used here with reference to the M0 and BM0 layers means that the M0 and BM0 layers are the interconnect layers of the frontside and backside interconnect structure, respectively, closest to the substrate and CFET devices (i.e., the active device layer). The M0 tracks may be tracks associated with, or of, a logic cell defined along the CFET rows 101, 102, whereas the BM0 tracks may correspondingly be tracks associated with, or of, the logic cell. By the term "frontside interconnect structure" is herein meant an interconnect structure (e.g., a back-end-of-line interconnect structure) comprising a vertical stack of interconnect layers (e.g., M0, M1, M2, etc.) arranged on a frontside of the semiconductor device 100, over the top transistor tier 100T. By the term "backside interconnect structure" is herein meant an interconnect structure comprising one or more interconnect layers arranged on a backside of the semiconductor device 100, below the bottom transistor tier 100B. The frontside and backside of the semiconductor device 100 may also be referred to as the frontside and backside of the active device layer, respectively. The frontside of the semiconductor device 100 / active device layer may correspond to a frontside and a backside of a substrate of the semiconductor device 100. By the term "interconnect layer" (frontside or backside) is herein meant a layer of horizontally routed (along the X and/or Y directions) interconnects, e.g., conductive traces, lines and/or line segments. An interconnect layer may also be referred to as a metal line layer, a metal routing layer or a metallization layer. Successive interconnect layers may be interconnected by intermediate via layers. The interconnect and via layers may be embedded in interlayer dielectrics.

The interconnects (e.g., lines, line segments, contacts) of a given interconnect layer may be arranged in (or along) any one of a set of routing tracks in the given interconnect layer. In the present disclosure, the routing tracks of each layer referred to are assumed to be unidirectional, extending in parallel in either the X direction or the Y direction and being arranged with a substantially uniform pitch, or at least regular pitch. As illustrated in the drawings, the M0 tracks extend in parallel in the X direction. This applies correspondingly to the BM0 tracks. As per se is known to the skilled person, an interconnect such as a line or line segment arranged in any given routing track need not extend along the full length of the track, but need only be disposed to define an overlap with respect to the structures that are to be interconnected, such as a contact or LI of a logic cell. Further, some routing tracks may even be unused, depending on the routing requirements of the specific logic cell implementation.

Fig. 1 indicates with dashed lines by way of example locations of a pair of opposite cell boundaries B 1, B2 of a logic cell. The cell boundaries B 1, B2 extend in parallel in the X direction. The cell boundaries B 1, B2 are here aligned with the BM0-1 and BM0-5 tracks, the BM0-1 and BM0-5 tracks thus defining a pair of backside "edge tracks" for the logic cell. As further may be seen, the center line of the logic cell, and thus the row of LIs 180 are aligned with the BM0-3 track which thus defines a backside "center track" for the logic cell. The first and second CFET rows 101, 102 are aligned with the BM0-2 and BM0-4 tracks, the BM0-2 and BM0-4 tracks thus defining a pair of backside "off-center tracks" for the logic cell. Correspondingly, in the frontside interconnect structure, the cell boundaries B 1, B2 are aligned with the pair of "outer tracks" M0-1, M0-7, while the center line of the logic cell, and the row of LIs 180, are aligned with the "center track" M0-4. The further tracks M0-2, M0-3 and M0-5, M0-6 define respective pairs of "off-center tracks", between the edge and center tracks M0-1, M0-4 and M0-4, M0-7, respectively.

In the illustrated example of Fig. 1, the bottom power rails 152, 162 are arranged in respective BM0 tracks, BM0-1 and BM0-5. The top power rails 154, 164 are arranged in the top transistor tier 100T (i.e., below the M0 layer). In another implementation, the bottom power rails 152, 162 may analogous to the top power rails 154, 164 be arranged in the bottom transistor tier 100T. In this case, the top power rails 154, 164 may be formed with a smaller vertical dimension, e.g., so as not to extend into the bottom transistor tier 100B. While not specifically shown in Fig. 1, the top power rails 154, 164 may define local pull-down or pull-up rails for the top transistor tier 100T and be connected to a corresponding global power rail 170 that may be disposed in the BM0-3 track. The connection may be provided in a region of the semiconductor device 100 outside the logic cell, e.g., in a region where the connection may be provided without competing for routing resources with connections between bottom and top transistors of the CFET rows 101, 102.

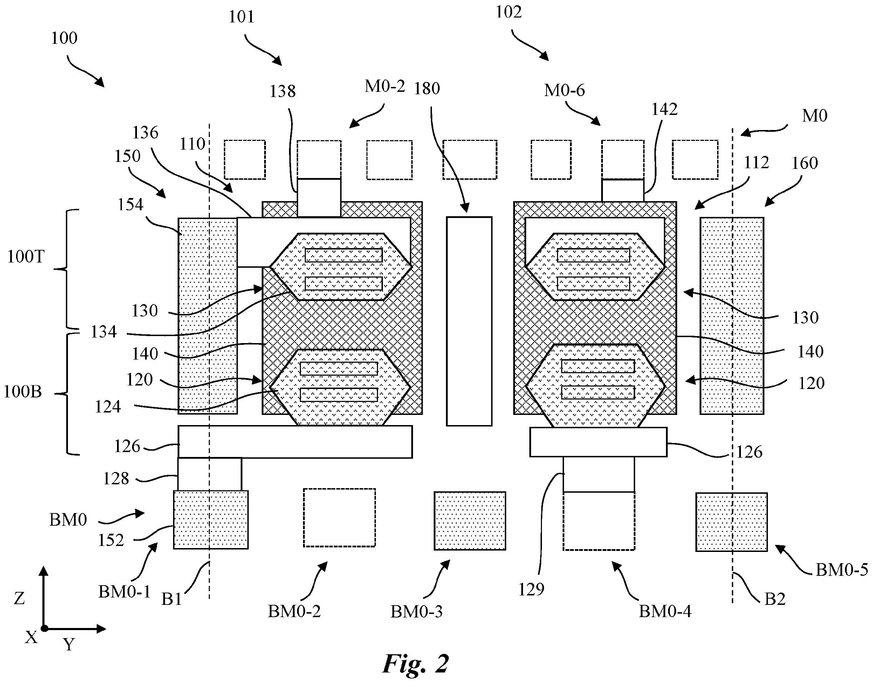

Fig. 2 illustrates a further example implementation of a double-row CFET. Fig. 2 is similar to Fig. 1, but further shows how a connection between the bottom S/D 124 of the first CFET device 110 and the bottom power rail 152 may be realized by arranging the bottom S/D contact portion 126 to extend laterally to overlap the bottom edge track BM0-1 and the cell boundary B1, and contacting / tapping the bottom power rail 152 by a backside contact or via 128.

Fig. 2 further illustrates how the bottom S/D contact portion 126 of the second CFET 112 may be connected to a signal routing resource in the backside off-center track BM0-4 by a backside contact or via 129. Fig. 2 further illustrates that the top S/D 134 may be connected / tapped to the top power rail 154 by arranging the top S/D contact portion 136 to laterally extend towards the cell boundary B1 to contact / abut the top power rail 154. As further shown in Fig. 2, the top S/D contact portion 136 of the first CFET device 110 may alternatively be coupled to a signal routing resource in an overlapping M0 track, here exemplified by the M0-2 track, by a via 138. As further shown, the gate 140 of the CFET 10 may be coupled to a signal routing resource in an overlapping M0 track, here exemplified by the M0-6 track, by a gate via 142.

According to an example fabrication process for the double-row CFET structure, the CFET device processing may be monolithic, wherein both top and bottom transistors are patterned together with a single active and dummy gate etch. The S/D regions may be formed by cutting the active between the dummy gates, blocking the top-device and growing a highly doped S/D region epitaxially for the bottom transistor. After depositing isolation layers covering the bottom S/D region, the S/D region for the top transistor may be grown. The dummy gate may then be removed, the nanosheets released, and the gate filled with the replacement metal to form the functional / active gates of the CFET devices. In a next step top contact trenches (MDT) may be formed together with a "hanging" downward trench for the row of LIs. After completing the frontside back-end-of-line (FS-BEOL), and thus forming the frontside interconnect structure, the wafer may be bonded to a carrier wafer, flipped and the original wafer removed giving access again to the bottom transistors. Bottom contact trenches (MDB) for bottom S/D contacts may be formed. The process may then be finalized by formation of the backside interconnect structure.

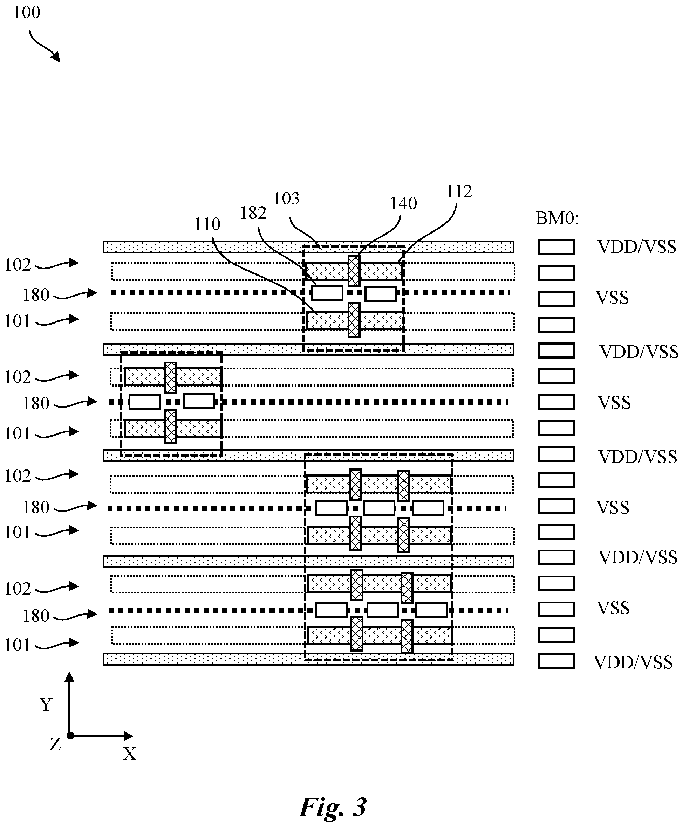

In the following, example implementations of semiconductor devices and logic cells based on the double-row CFET design, as shown in the above, will be discussed with reference to Fig. 3-9. Where appropriate, like reference signs will be used to refer to like elements, unless stated otherwise. For instance, reference signs 101, 102 refer to first and second CFET rows. It is further to be noted that each of the CFET devices referred to in the following may have a configuration corresponding to either of CFET devices 110, 120 of Fig. 1-2.

Fig. 3 schematically shows a top-down view of a floorplan of a semiconductor device 100 comprising a plurality of double-row CFETs, each comprising a respective pair of a first and second CFET row 101, 102. The rectangular areas, such as the area denoted 103, generally indicate locations of logic cells, such as logic standard cells. The locations of backside tracks BM0 is schematically indicated in the right-hand side portion of the drawing area. As may be understood from the above, each track designated by "VDD/VSS" indicates a power routing track for a stacked power rail structure corresponding to power rail structures 150, 160 of Fig. 1-2. Accordingly, each backside track designated "VDD/VSS" indicates a location of a VDD bottom power rail and further comprises a VSS top power rail arranged over the VDD bottom power rail (or vice versa). The backside tracks designated "VSS" indicates a location of a global VSS (or VDD) power rail. As exemplified for the cell 103, each cell comprises a number of LIs 182 of the associated row of LIs 180 extending through the cell, a number of CFET devices 110, 112 of the associated first and second CFET rows 101, 102, each comprising a shared gate 140.

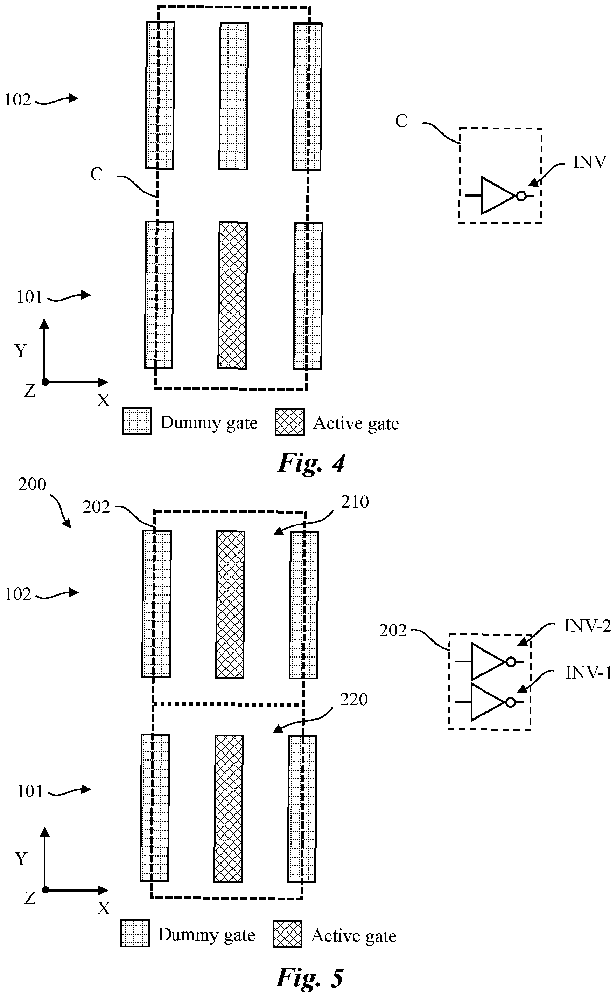

Fig. 4 schematically shows, as a comparative example, a logic cell C comprising a double-row CFET implementing a single inverter gate INV. The double-row CFET as such enables low-track height implementations of logic cells. However, implementing a logic gate in this manner using only one row of the double-row effectively results in half the height dimension of the cell (in the Y direction) being unused. A logic cell implemented in accordance with Fig. 4 may herein be referred to as a single-bit logic cell, as it only provides a single-bit output.

Fig. 5 schematically shows a semiconductor device 200 comprising a logic cell 202 which in accordance with the present disclosure instead implements two inverter (NOT) gates INV-1, INV-2 using the double-row CFET. Hence, the cell area which in the comparative example of Fig. 4 is un-used, is here utilized to accommodate a further inverter gate. The logic cell 202 hence realizes a multi-bit (e.g., 2-bit input/output inverter) cell, effectively doubling the area usage of the logic cell 202. The inverters INV-1, INV-2 are arranged in respective half-cells 210, 220 of the logic cell 202. The partitioning of the logic cell 202 into the half-cells 210, 220 is here schematically indicated by a dotted line inner boundary corresponding to a center line of the logic cell 202. The location of the respective CFET devices of the first and second inverter gates is here only schematically indicated by the location of their respective active gates. Each active gate is as shown surrounded by a pair of dummy gates, arranged on opposite cell boundaries of the logic cell 202.

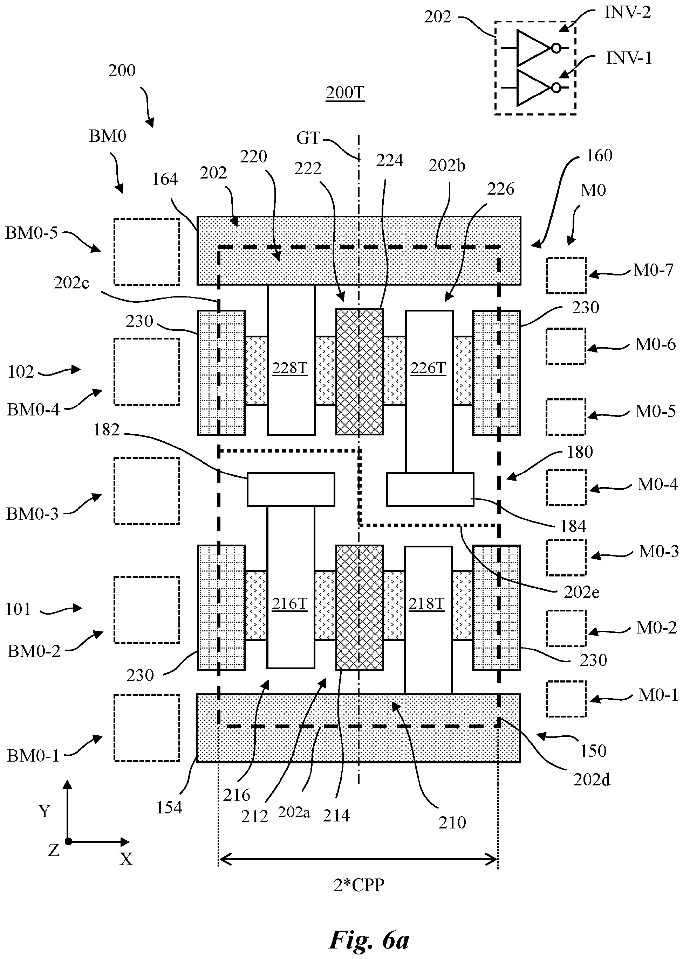

The logic cell 202 will now be described in further detail with reference to Fig. 6a-b, showing example layouts of the top and bottom transistor tiers 200T, 200B, respectively, of the logic cell 202.

The semiconductor device 200 comprises a first and second power rail structure 150, 160 extending in parallel in the X direction, and each comprising a bottom power rail 152, 162 (e.g., VDD) and a top power rail 154, 164 (e.g., VSS) arranged vertically above the bottom power rail 152, 162. The semiconductor device 200 further comprises a row of LIs 180 arranged between and extending in the X direction, in parallel to the first and second power rail structures 150, 160. The row of LIs 180 may as shown be arranged on (i.e., be substantially aligned with) a centerline of the logic cell 202. The semiconductor device 200 further comprises a first and second row of CFET devices 101, 102 extending in the X direction, in parallel to the first and second power rail structures 150, 160. The first row of CFET devices 101 is arranged between the first power rail structure 150 and the row of LIs 180. The second row of CFET devices 102 is arranged between the second power rail structure 160 and the row of LIs 180. The first row of CFET devices 101 may as shown be arranged on (i.e., be substantially aligned with) a centerline between the first power rail structure 150 and the row of LIs 180. Correspondingly, the second row of CFET devices 102 may be arranged on (i.e., be substantially aligned with) a centerline between the second power rail structure 160 and the row of LIs 180.

The logic cell 202 has first and second cell boundaries 202a, 202b extending in parallel in the X direction. The distance between the first and second cell boundaries 202a, 202b define a cell height of the logic cell 202. The logic cell 202 further has third and fourth cell boundaries 202c, 202d extending in parallel in the Y direction. The distance between the third and fourth cell boundaries 202c, 202d define a cell width of the logic cell 202. The first and second cell boundaries 202a-b are respectively aligned with the first and second power rail structures 150, 160. Thus, the first and second power rail structures 150, 160 are arranged on the first and second cell boundaries 202a-b, respectively. The third and fourth cell boundaries 202c-d are respectively aligned with respective dummy gates 230 (see Fig. 6a). Thus, the dummy gates 230 are arranged on the third and fourth cell boundaries 202c-d. Due to the presence of the dummy gates 230, the logic cell 202 has a cell width (in the X direction) corresponding to 2*CPP, where CPP is the contacted poly pitch of the CFET devices 212, 222 of the logic cell 200.

The logic cell 202 comprises a first CFET device 212 of the first CFET row 101 and a second CFET device 222 of the second CFET row 102. The first and second CFET devices 212, 222 are arranged directly opposite each other, as seen in the Y direction. The first CFET device 212 is configured to implement the first logic gate, and the second CFET device 222 is configured to implement the second logic gate, the first and second logic gates here being respective inverters INV-1, INV-2.

The first CFET device 212 comprises a gate 214 shared by its bottom and top transistor. The second CFET device 222 comprises a gate 224 shared by its bottom and top transistor. The gates 214, 244 are as shown aligned in the Y direction, in other words arranged in or aligned with a common "gate track" GT.

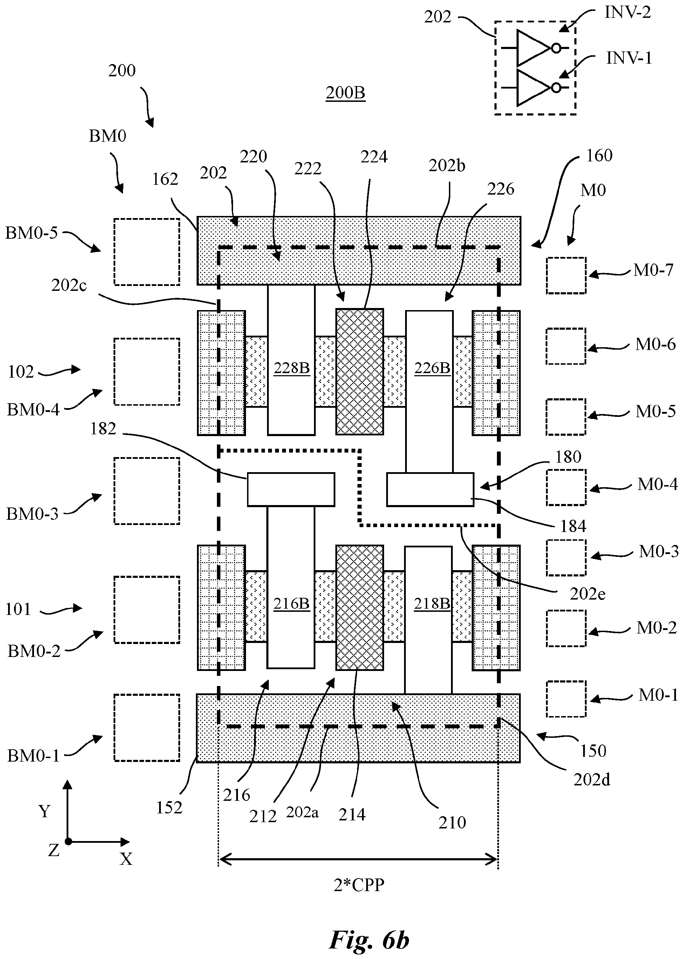

As may be seen in Fig. 6a, the top transistor of the first CFET device 212 is connected to the top power rail 154 by top S/D contact 218T. Correspondingly, the top transistor of the second CFET device 222 is connected to the top power rail 164 by top S/D contact 228T. As further may be seen in Fig. 6b, the bottom transistor of the first CFET device 212 is connected to the bottom power rail 152 by bottom S/D contact 218B. Correspondingly, the bottom transistor of the second CFET device 222 is connected to the bottom power rail 162 by bottom S/D contact 228B. Thus, the first CFET device 212 is connected between the first bottom and top power rails 152, 154. The second CFET device 222 is correspondingly connected between the second bottom and top power rails 162, 164. Thereby, the first power rail structure 150 is configured to power the first logic gate and the second power rail structure is configured to power the second logic gate 160.

The logic cell 202 further comprises a first LI 182 and a second LI 184 of the row of LIs 180. The first LI 182 is configured to interconnect a top and bottom S/D contact portion 216T, 216B of the first CFET device 212. The combination of the first LI 182 and the top and bottom S/D contact portions 216T, 216B form a first S/D contact structure 216. The second LI 184 is configured to interconnect a top and bottom S/D contact portion 226T, 226B of the second CFET device 212. The combination of the second LI 184 and the top and bottom S/D contact portions 226T, 226B form a second S/D contact structure 226. The first S/D contact structure 216 and the second S/D contact structure 226 are arranged on opposite sides of the common gate track of the gates 214, 224.

The gates 214, 224 of the first and second CFET devices are configured as input nodes of the respective logic gates INV-1, INV-2, and accordingly connected to a respective input pin of the logic cell 202. The first and second S/D contact structures 216, 226 are configured as output nodes of the respective logic gates INV-1, INV-2, and accordingly connected to a respective output pin of the logic cell 202. By the terms input and output "pin" of a logic cell is here meant a metal line or metal line segment connected to logic gate input / output nodes, respectively, to supply input signals to the respective logic gate and provide output signals from the respective logic gate. The input and output pins may typically be arranged in M0 tracks of the M0 frontside interconnect layer. For example, the input pin associated with the first logic gate INV-1 may be arranged in the M0-2 track and the input pin associated with the second logic gate INV-2 may for example be arranged in the M0-6 track. The output pin associated with the first logic gate INV-1 may for example be arranged in the M0-3 track and the input pin associated with the second logic gate INV-2 may for example be arranged in the M0-5 track. However, an opposite allocation of the input and output pins with respect to the M0-2, M0-3, M0-5 and M0-6 tracks is also possible. The input pins may be connected to the gates 214, 224 by a respective via, e.g., like the via 142 in Fig. 2. The output pins may be connected to the first and second S/D contact structures 216, 226 by a respective via, e.g., like the via 138 in Fig. 2.

As further shown in Fig. 6a, the logic cell 202 may be conceptually divided or partitioned by an inner boundary 202e into two sub-cells or half-cells 210, 220 of equal footprint. The first and second half-cells 210, 220 extend alongside each other in the cell width direction, i.e. in the X-direction. The first half-cell 210 comprises the first CFET device 212 and the second half-cell 220 comprises the second CFET device 222. Here, the inner boundary 202e is traced such that the respective LIs 182, 184 of the respective logic gates INV-1, INV-2 are comprised in the respective half-cells 210, 220, instead of as a straight line as in Fig. 5. This manner of representing the inner boundary 202e hence amounts to associating the respective LIs 182, 184 with their respective logic gates, rather than indicating the LIs 182, 184 as shared LIs of the logic cell 202 (which would be an equally valid depiction).

Accordingly, in view of the above, the first logic gate INV-1 is implemented by the first half-cell 210 comprising the first CFET device 212 and the first LI 182. The second logic gate INV-2 is implemented by the second half-cell 220 comprising the second CFET device 222 and the second LI 184. The layouts of the respective half-cells 210, 220 are as shown in Fig. 6a-b identical but rotated by 180 degrees relative each other, in other words flipped and mirrored relative each other. Put differently, the layout of the logic cell 202 is point symmetric, i.e., rotationally symmetric about the center of the logic cell 202. Hence, the (identical) first and second logic gates INV-1, INV-2 may be implemented by respective half-cells with identical layouts, and be accommodated within the footprint of a same logic cell 202.

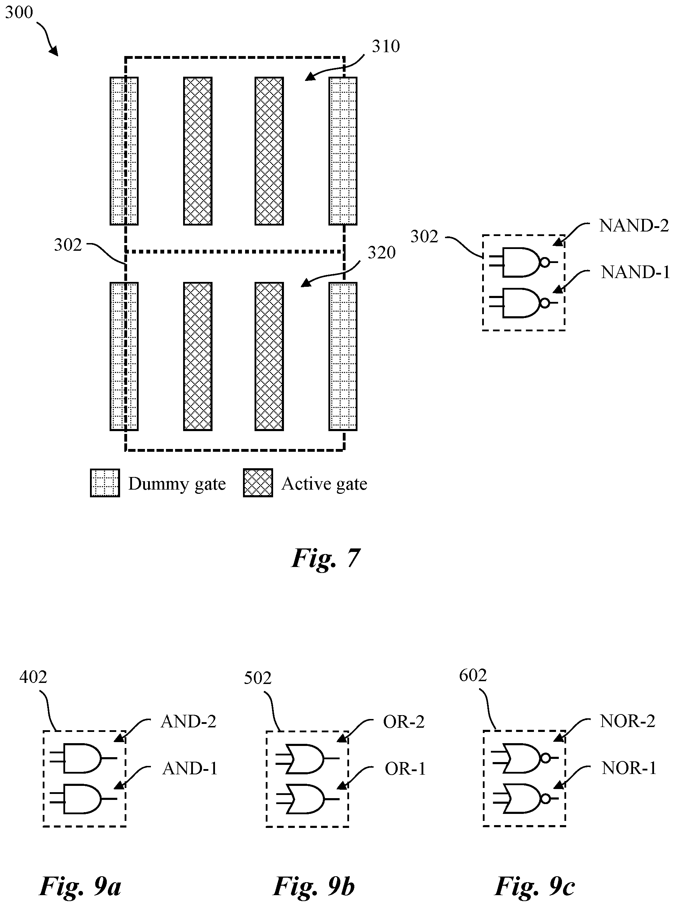

The logic gates of the logic cell 202 of Fig. 5 and 6a-b are each implemented by one (N = 1) CFET device of a respective CFET row 101, 102. The approach of implementing logic cells based on the double-row CFET discussed in the above may be applied in a corresponding manner to realize also other types of multi-bit logic gates, using N ≥ 2 CFET devices of each CFET row 101, 102. This is schematically depicted in Fig. 7 showing by way of example a schematic layout of a logic cell 302 of a semiconductor device 300, comprising a double-row CFET implementing two NAND gates NAND-1 and NAND-2 by two (N = 2) CFET devices of each CFET row 101, 102, each comprised in a respective half-cell 310, 320.

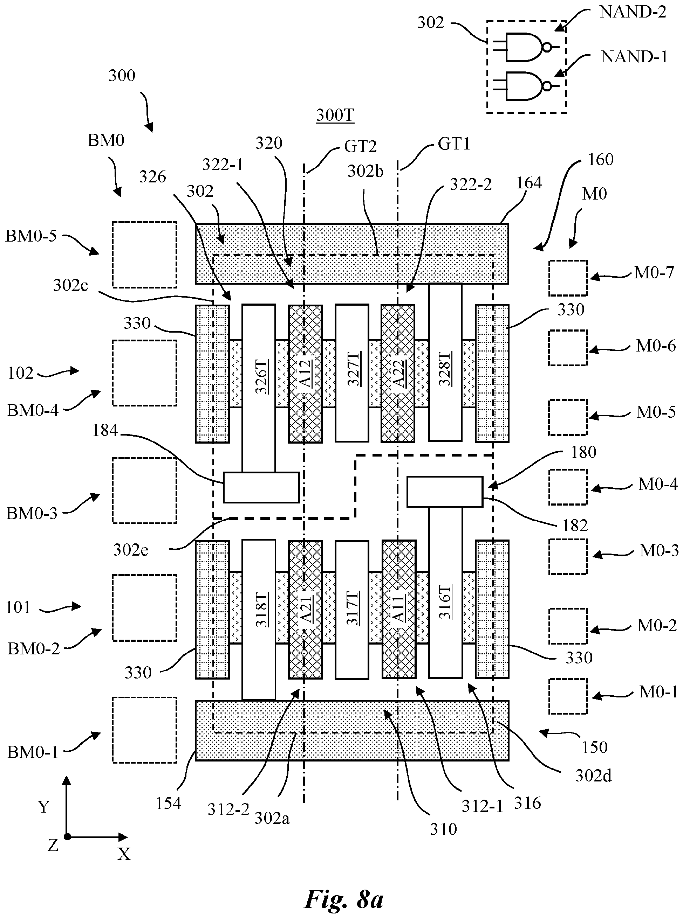

The logic cell 202 will now be described in further detail with reference to Fig. 8a-b, showing example layouts of the top and bottom transistor tiers 300T, 300B, respectively, of the logic cell 302.

To realize the 2-bit input of a NAND gate, the first and second logic gates NAND-1, NAND-2 are here each implemented by two respective CFET devices 312-1, 312-2 and 322-1, 322-2, respectively. The logic cell 302 may as shown, like the logic cell 202, be divided into two respective half-cells 310, 320, the first half-cell 310 implementing the first logic gate NAND-1 and the second half-cell 320 implementing the second logic gate NAND-2. The CFET device 312-1 may here be referred to as the first CFET device 312-1 of the logic cell 302 and the CFET device 322-1 may be referred to as the second CFET device 322-1 of the logic cell 302.

Each CFET device 312-1, 312-2, 322-1, 322-2 comprises a respective gate A11, A21, A12, A22 shared by its bottom and top transistor. The gates A11 and A22 are as shown aligned in the Y direction, in other words arranged in or aligned with a common first "gate track" GT1. Correspondingly, the gates A21 and A12 are aligned in the Y direction, in other words arranged in or aligned with a common second "gate track" GT2 parallel to the first gate track.

The logic cell 302 further comprises a first LI 182 and a second LI 184 of the row of LIs 180. The first LI 182 is configured to interconnect a top and bottom S/D contact portion 316T, 316B of the first CFET device 312-1. The combination of the first LI 182 and the top and bottom S/D contact portions 316T, 316B form a first S/D contact structure 316. The second LI 184 is configured to interconnect a top and bottom S/D contact portion 326T, 326B of the second CFET device 322-1. The combination of the second LI 184 and the top and bottom S/D contact portions 326T, 326B form a second S/D contact structure 326. Analogous to the discussion of the half-cells 210, 220 of the logic cell 202 of Fig. 6a-b, the first LI 182 and the first S/D contact structure 316 is comprised in the first half-cell 310 and the second LI 184 and the second S/D contact structure 326 is comprised in the second half-cell 320.

The further connections of the respective CFET devices 312-1, 312-2, 322-1, 322-2 of the respective logic gates NAND-1, NAND-2 / half-cells 310, 320, to each other as well as to the respective power rail may be readily seen in Fig. 7a-b.

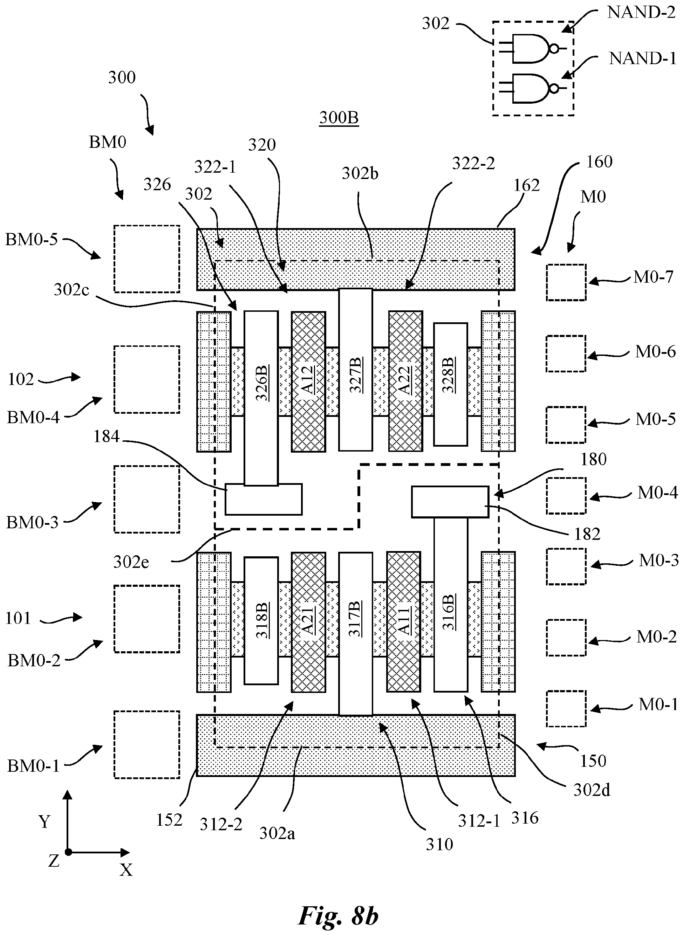

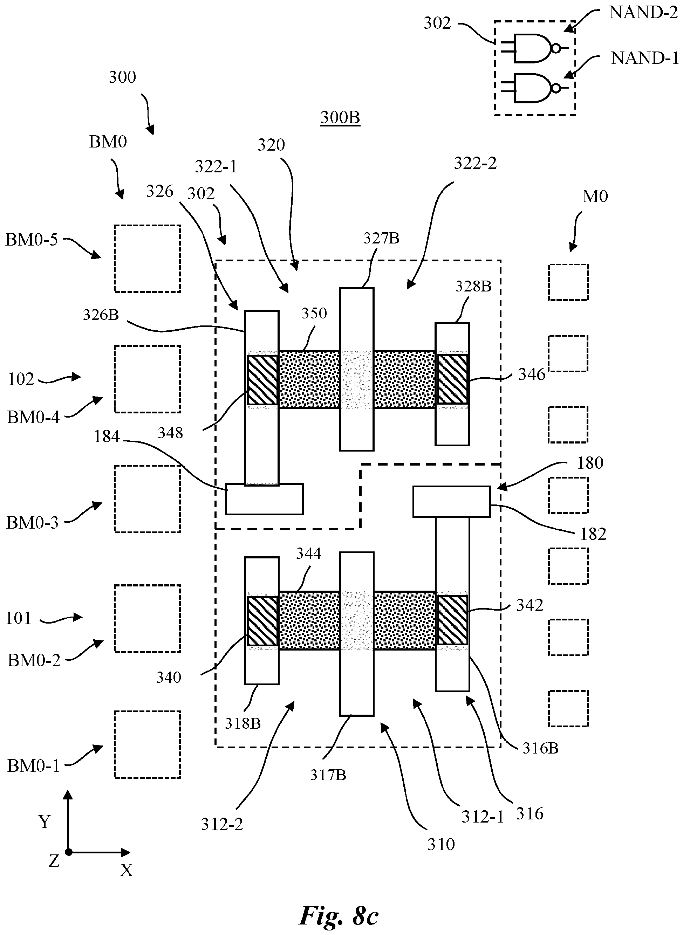

The top and bottom S/D contacts 317T, 317B are shared by the CFET devices 312-1 and 312-2. Correspondingly, the top and bottom S/D contacts 327T, 327B are shared by the CFET devices 322-1 and 322-2. As may be seen in Fig. 8a, the bottom transistor of the CFET devices 312-1 and 312-2 are connected to the bottom power rail 152 by bottom S/D contact 317B. Correspondingly, the bottom transistor of the CFET devices 322-1 and 322-2 are connected to the bottom power rail 162 by bottom S/D contact 327B. As further may be seen in Fig. 8b, the top transistor of the CFET device 312-2 is connected to the top power rail 154 by top S/D contact 318T. Correspondingly, the top transistor of the CFET device 322-2 is connected to the top power rail 164 by top S/D contact 328T. To complete the signal routing involved in a NAND gate, a connection is further needed between, on the one hand, the bottom S/D contact 318B and the S/D contact structure 316, and on the other hand, between the bottom S/D contact 328B and the S/D contact structure 326. Fig. 8c is a further view of the bottom tier 300B of the logic cell 302, however omitting some elements to allow a view of the backside interconnect layer BM0. Thus, as may be seen in Fig. 8c, to realize these connections, each logic gate NAND-1, NAND-2 may utilize a metal line 344, 350 disposed in a respective backside signal track BM0-2, BM0-4 aligned with the respective CFET rows 101, 102. The metal line 344 is connected to the bottom S/D contacts 316B and 318B by a pair of backside contacts 340, 342 (e.g., analogous to the backside contact 129 of Fig. 2). The metal line 350 is correspondingly connected to the bottom S/D contacts 326B and 328B by a pair of backside contacts 346, 348. The respective metal lines thus interconnect a pair of non-neighboring S/Ds of a respective pair of CFET devices of the respective CFET row 101, 102, i.e. 312-1 and 312-2, and 322-1 and 322-2.

The gates A11, A21, A12, A22 of the CFET devices 312-1, 312-2, 322-1, 322-2 are configured as input nodes of the respective logic gates NAND-1, NAND-2, and accordingly connected to a respective input pin of the logic cell 302. The first and second S/D contact structures 316, 326 are configured as output nodes of the respective logic gates NAND-1, NAND-2, and accordingly connected to a respective output pin of the logic cell 302. For example, the two input pins associated with the first logic gate NAND-1 may be arranged in the M0-2 track and the two input pins associated with the second logic gate INV-2 may for example be arranged in the M0-6 track. The output pin associated with the first logic gate NAND-1 may for example be arranged in the M0-3 track and the output pin associated with the second logic gate NAND-2 may for example be arranged in the M0-5 track. However, different allocations of the input and output pins with respect to the M0-2, M0-3, M0-5 and M0-6 tracks are also possible. As discussed with reference to Fig. 6a-b, the connections between the input / output pins and the gates and S/D contacts of the logic cell 302 may be realized by vias.

The respective CFET devices 312-1, 312-2 and 322-1, 322-2 are like in the inverter implementation of Fig. 6a-b surrounded by respective pairs of dummy gates 330, aligned with third and fourth cell boundaries 302c-d of the logic cell 302. Thus, the logic cell 302 has a cell width (in the X direction) corresponding to (N+1)*CPP = 3*CPP.

Similar approaches may be applied to realize multi-bit AND-gates (Fig. 9a, logic cell 402 comprising first and second AND-gates AND-1, AND-2), multi-bit OR-gates (Fig. 9b, logic cell 502 comprising first and second OR-gates OR-1, OR-2), and multi-bit NOR-gates (Fig. 9c, logic cell 602 comprising first and second NOR-gates NOR-1, NOR-2).

The logic cells 402, 502, 602 may each, like the logic cell 302 of Fig. 8a-b, be implemented by three transistors of the respective CFET rows 101, 102, and each may have a cell width of 3*CPP. The logic cells 402, 502, 602 may each utilize routing resources in the backside routing layer BM0 to interconnect a pair of non-neighboring S/Ds of a respective pair of CFET devices of the respective CFET row 101, 102, as was shown for the NAND gate logic cell 302 of Fig. 8a-c.

A standard cell library including both single-bit logic cells (utilizing only a single row of the CFET-double row, such as the example cell C of Fig. 4) and multi-bit logic cells (utilizing both rows of the CFET double row, such as the cells 202, 302, 402, 502, 604 of Fig. 5, 6a-b, 7, 8a-b and 9a-c) may provide flexibility in the circuit design flow. For example, closely spaced single-bit logic cells (e.g., each implementing a respective inverter gate) may be aggregated to form a multi-bit logic cell (e.g., implementing two inverter gates), thus replacing the two single-bit logic cells and improving area utilization. Conversely, a multi-bit logic cell (e.g., implementing two AND gates) may be split into two single-bit logic cells (e.g., each implementing a respective AND gate) thus replacing the multi-bit logic cell with two single-bit logic cells. While this may reduce area utilization for the given multi-bit logic cell, this may in some instances still be beneficial if it enables a more efficient routing of signals between the logic gates and surrounding logic cells. These approaches of aggregating and splitting logic cells may for example be implemented during place and route in an Electronic Design Automation (EDA) tool.

The person skilled in the art realizes that the present invention by no means is limited to the examples described above. On the contrary, many modifications and variations are possible within the scope of the appended claims. For instance, it is contemplated that the approaches presented in the above also may be applied to realize logic cells based on the double-row CFET implementing first and second logic gates which not necessarily are identical, but that may be implemented by a same number of CFET devices of a CFET row, and thus by respective half-cells of the same cell width, e.g., (N+1)*CPP. Hence, the cell area which in the comparative example of Fig. 4 is un-used, could be realized to accommodate a further inverter gate.

## Claims

1. A semiconductor device (200) comprising:
a first and second power rail structure (150, 160) extending in parallel, each comprising a bottom power rail (152, 162) and a top power rail (154, 164) arranged above the bottom power rail (152, 162);
a row of local interconnects (180) arranged between and extending in parallel to the first and second rows of CFET devices (101, 102);
a first and second row of complementary field-effect transistor, CFET, devices (101, 102) extending in parallel to the first and second power rail structures (150, 160), wherein the first row of CFET devices (101) is arranged between the first power rail structure (150) and the row of local interconnects (180), and the second row of CFET devices (102) is arranged between the second power rail structure (160) and the row of local interconnects (180); and
a logic cell (202) comprising:
at least one CFET device (212) of the first row of CFET devices (101) configured to implement a first logic gate, and a first local interconnect (182) of the row of local interconnects (180) configured to interconnect a top and bottom source/drain, S/D, of a first CFET device (212) of the at least one CFET device (212) of the first row of CFET devices (101); and
at least one CFET device (222) of the second row of CFET devices (102) configured to implement a second logic gate, and a second local interconnect (184) of the row of local interconnects (180) configured to interconnect a top and bottom S/D of a second CFET device (212) of the at least one CFET device (212) of the second row of CFET devices (101),
wherein the first logic gate is connected to first input and output pins of the logic cell (202) and the second logic gate is connected to second input and output pins of the logic cell (202), and
wherein the first power rail structure (150) is configured to power the first logic gate and the second power rail structure (160) is configured to power the second logic gate.

2. The semiconductor device (200) according to claim 1, wherein the logic cell (202) further comprises:
a first S/D contact structure (216) comprising a bottom S/D contact portion (216B) contacting the bottom S/D of the first CFET device (212), a top S/D contact portion (216T) contacting the top S/D of the first CFET device (212), and the first local interconnect (182) interconnecting the bottom and top S/D contact portions (216B, 216T); and
a second S/D contact structure (226) comprising a bottom S/D contact portion (226B) contacting the bottom S/D of the second CFET device (222), a top S/D contact portion (226T) contacting the top S/D of the second CFET device (222), and the second local interconnect (182) interconnecting the bottom and top S/D contact portions (226B, 226T).

3. The semiconductor device (200) according to claim 2, wherein the first S/D contact structure (216) is connected to the first output pin of the logic cell (202) and the second S/D contact (226) is connected to the second output pin of the logic cell (202).

4. The semiconductor device (200) according to any one of the preceding claims, wherein each of the CFET devices (212, 222) comprises a gate (214, 224) shared by a bottom and top transistor of the respective CFET device (212, 222) and connected to a respective input pin of the logic cell (202).

5. The semiconductor device (200, 300) according to any one of the preceding claims, wherein the first logic gate is implemented by N ≥ 1 CFET devices of the first row of CFET devices (101) and second logic gate is implemented by N CFET devices of the second row of CFET devices (102).

6. The semiconductor device (200) according to claim 5, wherein the at least one CFET device of first logic gate and the at least one CFET device of the second logic gate are arranged in respective half-cells (210, 220) of the logic cell (202), and wherein each half-cell (210, 220) has a cell width corresponding to (N+1) times a contacted poly pitch, CPP, of the CFET devices (212, 222).

7. The semiconductor device (200) according to any one of claims 5-6, wherein each half-cell (210, 220) comprises a respective pair of dummy gates (230), wherein the N CFET devices of each logic gate (202) is arranged between the respective pair of dummy gates.

8. The semiconductor device (200) according to any one of claims 5-7, wherein N ≥ 2 and wherein the logic cell (202) comprises a respective backside signal track aligned with each of the first and second rows of CFET devices (101, 202) and each comprising a metal line interconnecting a pair of non-neighboring S/Ds of a pair of CFET devices of the respective row of CFET devices (101, 102).

9. The semiconductor device of any one of the preceding claims, wherein the first and second logic gates are identical logic gates.

10. The semiconductor device according to claim 9, wherein a circuit layout of the logic cell (202) is point symmetric.

11. The semiconductor device according to any one of claims 9-10, wherein the first and second logic gates are inverter gates, NAND gates, NOR gates, AND gates or OR gates.

12. The semiconductor device (200) according to claim 10, when dependent on claim 5, wherein:
N=1 and the first and second logic gates are inverter gates, or
N=2 and the first and second logic gates are AND, OR, NOR or NAND gates and N=2.

13. The semiconductor device according to claim 1, wherein the bottom power rails (152, 162) are arranged in a bottom transistor tier (100B) comprising the bottom transistors of the first and second rows of CFET devices (101, 102), or in a backside interconnect layer (MB0), and/or wherein the top power rails (1032, 1042) are arranged in a top transistor tier (100T) comprising the top transistors of the first and second rows of CFET devices (101, 102).
